# EUROPÄISCHE PATENTSCHRIFT

(11) **EP 1 890 378 B1**
(45) Veröffentlichungstag und Bekanntmachung des Hinweises auf die Patenterteilung: **28.03.2012**
(21) Anmeldenummer: 07014019.9
(22) Anmeldetag: 17.07.2007
(51) Int. Cl.: H03B 19/14

(54) **Frequenzvervielfacher-Anordnung mit Referenz-Detektor**
Frequency multiplier assembly with reference detector
Agencement de multiplicateur de fréquence doté d'un détecteur de référence

(30) Priorität: 16.08.2006 DE 102006038075
(43) Veröffentlichungstag der Anmeldung: 20.02.2008
(73) Patentinhaber: Rohde & Schwarz GmbH & Co. KG, 81671 München (DE)
(72) Erfinder: Kraemer, Wilhelm, 83435 Bad Reichenhall (DE); Kuptz, Johannes, 85560 Ebersberg (DE); Richt, Norbert, 85570 Markt Schwaben (DE)
(74) Vertreter: Körfer, Thomas

(56) Entgegenhaltungen:
- US-A- 5 768 694
- US-A- 6 091 942

## Beschreibung

Das Gebiet der Erfindung betrifft eine Frequenzvervielfacher-Anordnung mit einem Frequenzvervielfacher, welche an einen Signalgenerator angeschlossen wird.

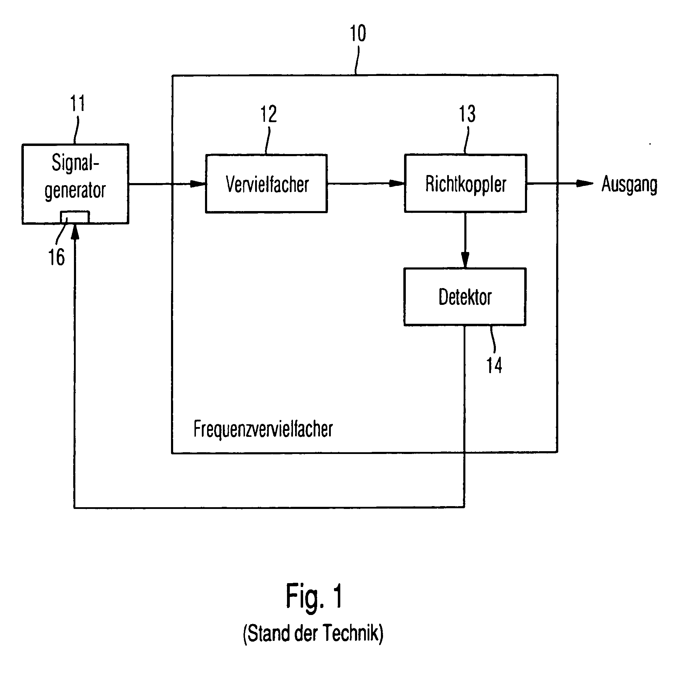

Für die Erzeugung eines erweiterten Frequenzbereiches können an einem Signalgenerator externe oder weitere Frequenzvervielfacher-Module angeschlossen werden. Um die Pegelregelung des Signalgenerators nutzen zu können, werden Teilsignale des Moduls wieder in den Signalgenerator eingespeist. Bei einer Frequenzvervielfacher-Anordnung gemäß dem Stand der Technik nach Fig. 1 geschieht die Rückkopplung des frequenzübersetzten Signals über eine Richtkoppler-/Diodendetektor-Strecke. Der Frequenzvervielfacher sowie die Richtkoppler-/Diodendetektor-Strecke besitzen jedoch eine Amplituden- und eine Frequenz-Charakteristik. Die Charakteristik des Frequenzvervielfachers muss durch die Regelung ausgeglichen werden. Die Charakteristik der Richtkoppler-/Diodendetektor-Strecke ist bekannt und kann vor der Einspeisung des Rückkopplungssignals in die Pegelregelung korrigiert werden.

Die Korrektur des Rückkopplungssignals vor Einspeisung in die Pegelregelung wird bei üblichen Signalgeneratoren durch den Einsatz eines programmierbaren Logikbausteines realisiert. Für die Umsetzung müssen jedoch teilweise unzulässige bzw. zu ungenaue Linearisierungen vorgenommen werden. Zudem treten temperaturabhängige Änderungen der Kennlinie auf, die in komplizierten Verfahren berücksichtigt werden müssen.

In der US 6 091 942 A ist ein Aufwärtswandler mit einem im Wesentlichen konstanten Verstärkungsgrad beschrieben. In dem Aufwärtswandler wird ein Eingangssignal in einem Eingangs-Sampler abgetastet und zum Einen einem Mischer, zum Anderen einem zweiten Detektor zugeführt. Das abgetastete Eingangssignal wird im Mischer in ein Hochfrequenz-Signal konvertiert und über einen Verstärker mit variablem Verstärkungsgrad sowie weiteren Verstärkern an einen Ausgangs-Sampler weitergeleitet. Im Ausgangs-Sampler wird das Hochfrequenz-Signal geteilt und einerseits als Ausgangssignal ausgegeben und andererseits an einen ersten Detektor weitergeleitet. Die Ausgangssignale des ersten und des zweiten Detektors werden nun einem Verstärkungsregler zugeführt, der den Unterschied zwischen den beiden Ausgangssignalen ermittelt und die Verstärkung im Verstärker mit variablen Verstärkungsgrad so einstellt, dass das Ausgangssignal des Mischers mit einem konstanten Verstärkungsgrad bzgl. des Eingangssignals verstärkt wird.

In ähnlicher Weise wird in der Patentschrift US 5 768 694 ein automatischer Verstärkungsregler beschrieben, in dem ein hochfrequentes Eingangssignal in einem Eingangssignalteiler geteilt wird. Ein erster Teil des Eingangssignals wird an einen programmierbaren Abschwächer und weiter über einen Verstärker zu einem Ausgangssignalteiler geführt. Ein Teil dieses Ausgangssignals wird an einen Ausgangsdetektor weitergeleitet, der die Amplitude des Ausgangssignals misst und an einen Regler weitergibt. Gleichzeitig wird ein zweiter Teil des Eingangssignals vom Eingangssignalteiler an einen Eingangsdetektor geleitet, der die Amplitude des Eingangssignals ermittelt und ebenfalls an den Regler weitergibt. Der Regler vergleicht die Amplituden und stellt den programmierbaren Abschwächer so ein, dass die Amplitude des Eingangs- bzw. Ausgangssignals gleich sind.

Ein Frequenzvervielfacher in nMOS-Technologie ist z. B. aus der US 2006/0152257 A1 bekannt.

Aufgabe der Erfindung ist es, eine Frequenzvervielfacher-Anordnung mit einer in der Umsetzung einfachen, kostengünstigen und dennoch möglichst genauen Pegelregelung des Ausgangssignals bereitzustellen.

Die Aufgabe wird durch die Merkmale des Anspruchs 1 gelöst. Vorteilhafte Weiterbildungen gehen aus den Unteransprüchen hervor.

Erfindungsgemäß wird einer Frequenzvervielfacher-Anordnung, welche einen Signalgenerator, einen Frequenzvervielfacher, und einen ersten Detektor aufweist, welcher dem Frequenzvervielfacher zur Detektion eines Pegelsignals nachgeschaltet ist, ein zweiter Detektor hinzugefügt, der dem Signalgenerator nachgeschaltet ist.

Dadurch ist es möglich ein Signal des ersten Detektors mit einem Signal des zweiten Detektors zu vergleichen.

In einer vorteilhaften Ausgestaltung wird ein, dem ersten Detektor identischer, zweiter Detektor eingesetzt. Bei der Verwendung identischer Detektoren, kann das Signal des zweiten Detektors direkt mit dem Ausgangssignal des ersten Detektors verglichen werden. Es müssen dann keine weiteren Umsetzungen des Signals des einen Detektors oder des anderen Detektors erfolgen.

In einer weiteren vorteilhaften Ausgestaltung ist der zweite Detektor mit dem ersten Detektor thermisch gekoppelt. Thermische Driften der Detektoren ändern die Kennlinien der beiden Detektoren im gleichen Maße, was zu stabileren Ausgangspegeln führt.

In einer weiteren vorteilhaften Ausgestaltung der Frequenzvervielfacher-Anordnung wird dem zweiten Detektor ein Hochfrequenz-Referenzsignal des Signalgenerators zugeführt. Damit ist es möglich vor einer Pegelregelung oder in einer Pegelregelungsschaltung auf eine ggf. komplizierte Kalibrierung des Referenzdetektorsignals zu verzichten. Dem Referenzdetektor kann ein definiertes Signal zugeführt werden, welches zudem vor der Zuführung zum zweiten Detektor oder zu einer Pegelregelung verstärkt bzw. in seiner Amplitude verändert werden kann.

In einer weiteren vorteilhaften Ausgestaltung wird das detektierte Signal des ersten Detektors und das detektierte Signal des zweiten Detektors der Pegelregelung des Signalgenerators zugeführt. Auf diese Weise kann die interne Regelungseinrichtung des Signalgenerators genutzt werden. Der Signalgenerator stellt gegebenenfalls mehrer Regelmöglichkeiten, Regler bzw. Reglertypen und/oder Möglichkeiten des Soll-/Istwertvergleiches bereit. Zudem kann ggf. auch auf Parameter wie voreingestellte Pegelwerte und Frequenzen bzw. Frequenzbereichsgrenzen zurückgegriffen werden.

In einer weiteren vorteilhaften Ausprägung wird in der Pegelregelung der dem Frequenzvervielfacher zugeführte Ausgangspegel des Signalgenerators so geregelt, dass das erste Detektorsignal mit dem zweiten Detektorsignal in Übereinstimmung gebracht wird.

Die Erfindung wird nachfolgend unter Bezugnahme auf die Zeichnungen näher beschrieben. In den Zeichnungen zeigen:
- Fig. 1: eine Frequenzvervielfacher-Anordnung gemäß dem Stand der Technik;
- Fig. 2: ein Ausführungsbeispiel einer erfindungsgemäßen Frequenzvervielfacher-Anordnung.

In einer Anordnung zur Frequenzvervielfachung gemäß dem Stand der Technik nach Fig. 1 verfügt ein externes Modul zur Frequenzvervielfachung 10 über einen Frequenzvervielfacher 12, einen Richtkoppler 13 und einen Detektor 14. Der Detektor 14 kann z.B. ein Diodendetektor sein.

Bei dem Frequenzvervielfacher-Anordnung gemäß dem Stand der Technik nach Fig. 1 generiert der Signalgenerator 11 ein Signal, welches in den Frequenzvervielfacher 12 eingespeist wird. Ein Teil des Ausgangssignals des Frequenzvervielfachers 12 wird über den Richtkoppler 13 ausgekoppelt und in den Detektor 14 eingespeist. Das Signal wird im Detektor 14 detektiert und dessen Pegel bestimmt. Dieser Pegel wird der Pegelregelung 16 des Signalgenerators 11 zugeführt. Diese regelt das Ausgangssignals des Signalgenerators 11 auf der Basis des Pegelsignals des Detektors 14.

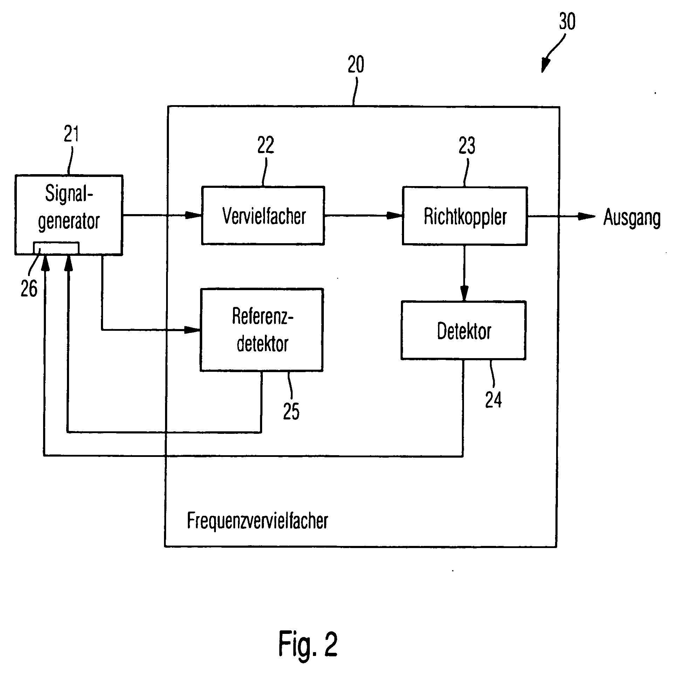

Auch bei der erfindungsgemäßen Anordnung zur Frequenzvervielfachung 30 nach Fig. 2 verfügt das externe Modul zur Frequenzvervielfachung 20 über einen Frequenzvervielfacher 22, einen Richtkoppler 23 und einen ersten Detektor 24. Der Frequenzvervielfacher 22 kann eine Phase Locked Loop sein oder die Frequenzvervielfachung kann einfach durch ein nicht lineares Verstärker-Element und ein Oberwellenfilter erzeugt werden. Als Detektoren 24 wird dabei vorzugsweise jeweils ein Diodendetektor eingesetzt. Zusätzlich verfügt das Frequenzvervielfacher-Modul über einen zweiten Detektor 25, der als Referenzdetektor fungiert und ebenfalls vorzugsweise ein Diodendetektor ist. Der erste Detektor 24 und der zweite Detektor 25 sind vorzugsweise baugleich bzw. identisch und thermisch gekoppelt.

Bei der erfindungsgemäßen Frequenzvervielfacher-Anordnung 30 wird das Ausgangssignal des Signalgenerators 21 zunächst einem Frequenzvervielfacher 22 zugeführt und von diesem in seiner Frequenz um einen gewissen Faktor erhöht. Das Ausgangssignal des Frequenzvervielfachers 22 wird einem Richtkoppler oder einem sonstigen Koppler 23 zugeführt. Mit diesem wird ein Teil des Ausgangssignals des Frequenzvervielfacher 22 zur Bestimmung des Signal-Ist-Pegels in einen Detektor 24 eingespeist. Der Signal-Ist-Pegel wird der Pegelregelung 26 des Signalgenerators 21 zugeführt. Zusätzlich wird ein Hochfrequenz-Referenzsignal aus dem Signalgenerator 21 dem vorzugsweise mit dem ersten Detektor 24 thermisch gekoppelten und mit diesem identischen zweiten Detektor 25 zugeführt. Der zweite Detektor 25 erzeugt aus dem Hochfrequenz-Referenzsignal einen Signal-Soll-Pegel. Durch die Verwendung eines zweiten, mit dem ersten identischen Detektor, sowie die thermische Kopplung, wird es möglich einen direkten Vergleich der Ausgangssignale der Detektoren 24 und 25 durchzuführen selbst, wenn thermische Driften auftreten.

Die Pegelsignale werden der Pegelregelung 26 des Signalgenerators 21 zugeführt. Die Pegelregelung 26 sorgt für eine Angleichung des Signal-Ist-Pegels an den Signal-Soll-Pegel. Das Ausgangssignal der Detektoren 24 und 25 wird vorzugsweise vor der Einspeisung in die Pegelregelung 16 korrigiert, um die Kennlinie des Diodendetektors 14 zu berücksichtigen.

Die Erfindung ist nicht auf das beschriebene Ausführungsbeispiele beschränkt. Die erfindungsgemäße Anordnung kann vielfältig zum Einsatz kommen.

## Patentansprüche

1. Frequenzvervielfacher-Anordnung (30) mit einem Signalgenerator (21), einem Frequenzvervielfacher (22) und einem ersten Detektor (24), der dem Frequenzvervielfacher (22) nachgeschaltet ist, wobei die Frequenzvervielfacher-Anordnung (30) einen zweiten Detektor (25) umfasst, der baugleich zum ersten Detektor (24) ist und unmittelbar dem Signalgenerator (21) nachgeschaltet ist,
**dadurch gekennzeichnet,**
**dass** eine Pegelregelung (26) den dem Frequenzvervielfacher (22) zugeführten Ausgangspegel des Signalgenerators (21) so regelt, dass das erste Detektionssignal des ersten Detektors (24) mit dem zweiten Detektionssignal des zweiten Detektors (25) in Übereinstimmung gebracht wird.

2. Frequenzvervielfacher-Anordnung gemäß Anspruch 1,
**dadurch gekennzeichnet,**
**dass** der zweite Detektor (25) dem ersten Detektor (24) identisch ist.

3. Frequenzvervielfacher-Anordnung gemäß Anspruch 1 oder 2,
**dadurch gekennzeichnet,**
**dass** der zweite Detektor (25) mit dem ersten Detektor (24) thermisch gekoppelt ist.

4. Frequenzvervielfacher-Anordnung gemäß einem der Ansprüche 1 bis 3,
**dadurch gekennzeichnet,**
**dass** der zweite Detektor (25) mit einem Hochfrequenz-Referenzsignal des Signalgenerators (21) gespeist ist.

5. Frequenzvervielfacher-Anordnung gemäß einem der Ansprüche 1 bis 4,
**dadurch gekennzeichnet,**
**dass** ein vom ersten Detektor (24) detektiertes erstes Detektorsignal und ein vom zweiten Detektor (25) detektiertes zweites Detektorsignal dem Signalgenerator (21) zur Pegelregelung zugeführt ist.

## Claims

1. Frequency multiplier arrangement (30) having a signal generator (21), a frequency multiplier (22) and a first detector (24), which is connected downstream of the frequency multiplier (22), wherein the frequency multiplier arrangement (30) comprises a second detector (25), which is of the same design as the first detector (24) and is connected directly downstream of the signal generator (21),
**characterized**
**in that** a level controller (26) regulates the output level of the signal generator (21), which output level is supplied to the frequency multiplier (22), such that the first detection signal from the first detector (24) is brought into line with the second detection signal from the second detector (25).

2. Frequency multiplier arrangement according to Claim 1,
**characterized**
**in that** the second detector (25) is identical to the first detector (24).

3. Frequency multiplier arrangement according to Claim 1 or 2,
**characterized**
**in that** the second detector (25) is thermally coupled to the first detector (24).

4. Frequency multiplier arrangement according to one of Claims 1 to 3,
**characterized**
**in that** the second detector (25) is fed with a highfrequency reference signal from the signal generator (21).

5. Frequency multiplier arrangement according to one of Claims 1 to 4,
**characterized**
**in that** a first detector signal, detected by the first detector (24), and a second detector signal, detected by the second detector (25), are supplied to the signal generator (21) for the purpose of level control.

## Revendications

1. Système multiplicateur de fréquence (30), comportant un générateur de signaux (21), un multiplicateur de fréquence (22) et un premier détecteur (24) monté en aval du multiplicateur de fréquence (22), ledit système multiplicateur de fréquence (30) comportant un deuxième détecteur (25) qui, par sa construction, est identique au premier détecteur (24) et est monté directement en aval du générateur de signaux (21),
**caractérisé en ce que**
un système de réglage de niveau (26) règle le niveau de sortie du générateur de signaux (21), lequel est acheminé vers le multiplicateur de fréquence (22), de telle sorte que le premier signal de détection du premier détecteur (24) est amené en concordance avec le deuxième signal de détection du deuxième détecteur (25).

2. Système multiplicateur de fréquence selon la revendication 1, **caractérisé en ce que** le deuxième détecteur (25) est identique au premier détecteur (24).

3. Système multiplicateur de fréquence selon la revendication 1 ou 2, **caractérisé en ce que** le deuxième détecteur (25) est couplé thermiquement au premier détecteur (24).

4. Système multiplicateur de fréquence selon l'une quelconque des revendications 1 à 3, **caractérisé en ce que** le deuxième détecteur (25) reçoit un signal haute fréquence de référence du générateur de signaux (21).

5. Système multiplicateur de fréquence selon l'une quelconque des revendications 1 à 4, **caractérisé en ce qu'**un premier signal de détection détecté par le premier détecteur (24) et un deuxième signal de détection détecté par le deuxième détecteur (25) sont acheminés vers le générateur de signaux (21) en vue du réglage du niveau.
